(19) Europäisches Patentamt
European Patent Office
Office européen des brevets

(11) Veröffentlichungsnummer: **0 492 225 A2**

(12) # EUROPÄISCHE PATENTANMELDUNG

(21) Anmeldenummer: **91121006.0**

(22) Anmeldetag: **07.12.91**

(51) Int. Cl.$^5$: **H01S 3/133**, G01B 9/02

(30) Priorität: **14.12.90 DE 4039955**

(43) Veröffentlichungstag der Anmeldung:
**01.07.92 Patentblatt 92/27**

(84) Benannte Vertragsstaaten:
**CH DE FR GB LI NL SE**

(71) Anmelder: **Firma Carl Zeiss**
**W-7920 Heidenheim (Brenz)(DE)**
(84) **CH DE FR LI NL SE**

(71) Anmelder: **CARL-ZEISS-STIFTUNG, HANDELND ALS CARL ZEISS**
**W-7920 Heidenheim an der Brenz(DE)**
(84) **GB**

(72) Erfinder: **Vry, Uwe, Dr.**
**Auchtwiesenstrasse 17**
**W-7080 Aalen(DE)**

(54) **Anordnung mit zwei Laserdioden zur Erzeugung von Licht mit zwei Wellenlängen.**

(57) Die Wellenlängendifferenz zweier Laserdioden (1,2) wird durch Stabilisierung auf ein einziges Fabry-Perot-Interferometer (3) so gut stabilisiert, daß die Anwendung in der Zwei-Wellenlängen-Interferometrie und -Holografie möglich wird. Örtliche oder polarisationsmäßige Trennung der beiden Lichtbündel im Fabry-Perot-Interferometer.

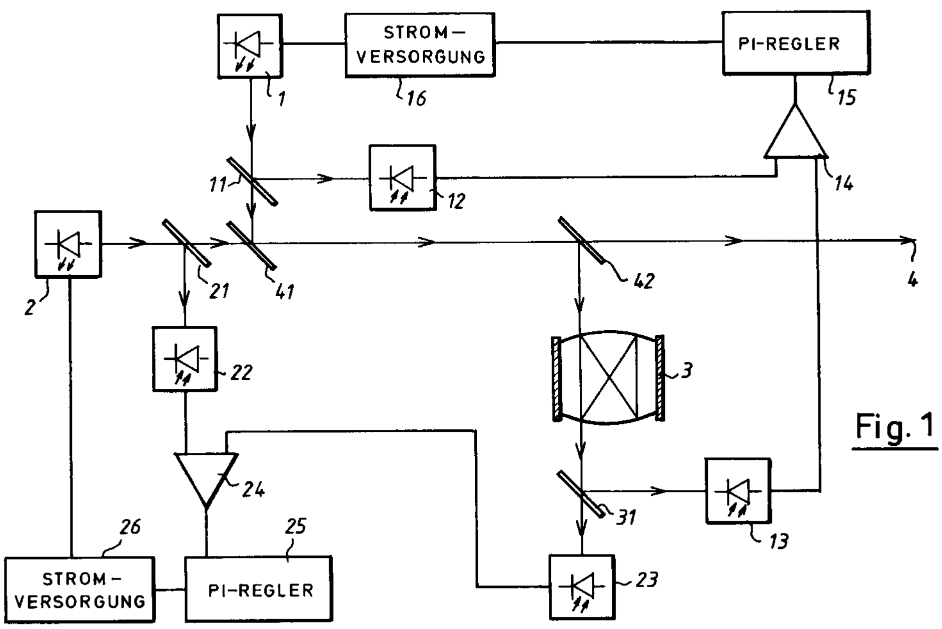


Fig. 1

EP 0 492 225 A2

Die Erfindung betrifft eine Anordnung mit zwei Laserdioden zur Erzeugung von Licht mit zwei Wellenlängen mit stabilisierter Wellenlängendifferenz.

Eine solche ist als Zweifrequenz-Laserinterferometer nach DE 36 16 393 A1 bekannt. Die Stabilisierung erfolgt hierbei durch mechanische, thermische und elektrische Kopplung der beiden Laserdioden aneinander. Insbesondere die langfristigen Wellenlängenänderungen von Laserdioden begrenzen die damit erreichbare Qualität.

Die Stabilisierung einer einzelnen Laserdiode mittels eines Fabry-Perot-Interferometers ist bekannt und bewährt.

Aus R. A. Valenzuela et al Electronics letters 24 (1988), 725 ist die Stabilisierung eines Fabry-Perot-Interferometers auf eine optische Referenz und die Stabilisierung einer weiteren Lichtquelle auf dieses Fabry-Perot-Interferometer bekannt. Dabei wird also ein Fabry-Perot-Interferometer mit zwei Lichtarten jeweils resonant betrieben, aber nur eine Lichtart, die der Laserdiode, wird als Nutz-Licht bereitgestellt.

Es ist die Aufgabe der Erfindung, eine gattungsgemäße Anordnung anzugeben, die hinsichtlich der Stabilität die Anforderungen der Zweiwellenlängen-Lasserinterferometrie und -Holografie dauerhaft erfüllt und dabei den Bauaufwand begrenzt.

Gelöst wird diese Aufgabe bei einer gattungsgemäßen Anordnung durch die kennzeichnenden Merkmale des Anspruches 1. Vorteilhafte Ausgestaltungen sind Gegenstand der Unteransprüche 1-5. Vorteilhafte Anwendungen sind Gegenstand der Unteransprüche 6-8.

Bei einigen Meßproblemen erweist sich Zweiwellenlängen-Interferometrie oder -Holografie als zweckmäßige Lösung. Darunter fallen z.B.:

- Interferometrische Messungen, bei denen die Wellenlänge sichtbaren Lichtes zu klein für ein eindeutiges Meßergebnis ist, z.B. absolute interferometrische Messung größerer Entfernung.
- Interferometrische Messungen an Oberflächen, deren Rauhigkeit vergleichbar mit der Wellenlänge oder größer als sie ist. In diesem Fall wird eine Messung mit einer einzelnen Wellenlänge durch den auftretenden Speckleeffekt stark erschwert oder sogar unmöglich gemacht. Mit zwei Wellenlängen sind jedoch aussagefähige Messungen möglich.
- Bei der Messung der Kontur ausgedehnter Objekte kann Zwei-Wellenlängen-Holografie eingesetzt werden.

Die in den einzelnen Fällen eingesetzten Verfahren sind im Detail durchaus verschieden. Gemeinsam ist ihnen jedoch das folgende Grundprinzip:

Zu messen ist eine optische Wegdifferenz z. Wird diese mit einer Wellenlänge $\lambda_i$ (i = 1,2) interferometrisch gemessen, so wird dazu die Phase

$$\Phi_i = \frac{2\pi}{\lambda_i} z \qquad \text{Gl. 1)}$$

bestimmt. Zieht man die Phasen $\Phi_1$ und $\Phi_2$ voneinander ab, erhält man die Phasendifferenz

$$\Phi = \Phi_2 - \Phi_1 = \frac{2\pi}{\Lambda} z \qquad \text{Gl. 2)}$$

Dabei ist

$$\Lambda = \frac{\lambda_1 \lambda_2}{\lambda_1 - \lambda_2} \qquad \text{Gl. 3)}$$

die sogenannte effektive oder synthetische Wellenlänge. Bei Betrachtung von $\Phi$ erhält man ein Interferogramm, das mit der effektiven Wellenlänge $\Lambda$ aufgenommen zu sein scheint, deren Größe durch entsprechende Wahl von $\lambda_1$ und $\lambda_2$ in recht großen Grenzen (zwischen einigen $\mu$m und mehreren Metern) variiert werden kann.

Die in Gleichung 2) notierte Differenzbildung wird bei einigen Verfahren explizit durchgeführt; bei anderen (z.B. der Zweiwellenlängen-Holografie) ist sie implizit enthalten.

Zur Erzeugung der beiden Wellenlängen gibt es die Möglichkeit der Verwendung zweier Laser, die die unterschiedlichen Wellenlängen erzeugen. Kritisch bei diesem Verfahren ist die Stabilität der beiden

Wellenlängen, wie aus der folgenden Rechnung zu ersehen ist.

Zur Berechnung der optischen Wegdifferenz z aus einem gemessenen $\Phi$ wird Gl. 2) umgestellt und $\Lambda$ durch den aus den Sollwerten der beiden Wellenlängen berechneten Wert $\Lambda_0$ ersetzt:

$$z = \Lambda_0 \cdot \frac{\Phi}{2\pi} \qquad \text{Gl. 4)}$$

$\Lambda_0$ ist hier also ein konstanter Faktor. Weichen die beiden Wellenlängen $\lambda_i$ von ihren Sollwerten um $d\lambda_i$ ab, so ändert sich ebenfalls der wirkliche Wert von $\Lambda$ und damit auch der Meßwert $\Phi$. Einsetzen von Gl. 2) und 3) in Gl. 4) und Bildung des vollständigen Differentials ergibt:

$$\frac{dz}{\Lambda_0} = \frac{z}{\lambda_1}\frac{d\lambda_1}{\lambda_1} - \frac{z}{\lambda_2}\frac{d\lambda_2}{\lambda_2} \qquad \text{Gl. 5)}$$

Zur Interpretation dieser Formel: Auf der linken Seite ist der Fehler dz auf die effektive Wellenlänge $\Lambda_0$ bezogen. Dieser Ausdruck muß, um sinnvolle Messungen zu ermöglichen, deutlich kleiner als 1 sein. Auf der rechten Seite stehen die relativen Wellenlängenstabilitäten, multipliziert mit der zu messenden optischen Wegdifferenz z in Einheiten der jeweiligen Wellenlänge. Zur Verdeutlichung ein Beispiel: Will man mit einer Wellenlänge von $1\mu m$ eine optische Wegdifferenz von 1m vermessen, so muß dazu die relative Wellenlängenstabilität $<10^{-6}$ sein, wenn in Gl. 5) nur eine Wellenlänge berücksichtigt wird und auf der linken Seite 1 steht. In der Praxis müssen deswegen im gegebenen Meßbeispiel die Wellenlängen stabiler als $10^{-7}$ sein, unabhängig von der gewählten effektiven Wellenlänge.

Für eine Wellenlänge wird diese Stabilität in bekannter Weise mittels eines Fabry-Perot-Interferometers erreicht.

Erfindungsgemäß wird die Stabilisierung zweier Laserdioden mit nur einem Fabry-Perot-Interferometer ausgeführt. Der Aufwand für das Fabry-Perot-Interferometer ist also nur einmal erforderlich, und dessen Restfehlereinflüsse sind für beide Wellenlängen einheitlich.

Dies wird mittels der Zeichnung näher erläutert.

Fig. 1 zeigt schematisch eine Anordnung in Ausführung mit Polarisationskennung, konfokalem Fabry-Perot-Interferometer und Flankenstabilisierung mit Hilfe von Referenzfotodioden.

Fig. 2 zeigt schematisch ein zweites Anführungsbeispiel mit örtlich getrennten Stahlengängen, planparallelem Fabry-Perot-Interferometer und Maximumstabilisierung nach dem Lock-In-Verfahren.

In Fig. 1 sind zwei temperaturstabilisierte Laserdioden (1) und (2), ein konfokales Fabry-Perot-Interferometer (3) und der aus der Anordnung austretende Lichtstrahl (4) dargestellt. Ein Teil des Lichts der beiden Laserdioden (1), (2) wird jeweils über Teilspiegel (11), (21) auf Referenz-Fotodioden (12), (22) gelenkt. Durch einen polarisierenden Teilspiegel (41) wird das Licht der beiden Laserdioden (1), (2) zugleich zueinander orthogonal linear polarisiert und in einem Strahl vereinigt. Davon zweigt ein Strahlteiler (42) einen Teil ab, der Hauptteil des Lichts steht als Ausgangsstrahl (4) zur Nutzung zur Verfügung.

Der am Strahlteiler 42 abgezweigte Teil des Lichts wird in das konfokale Fabry-Perot-Interferometer (3) eingekoppelt. Das aus dem Fabry-Perot-Interferometer (3) austretende Licht wird durch einen polarisierenden Strahlteiler in die von den Leuchtdioden (1) und (2) kommenden Anteile zerlegt. Diese Licht-Anteile werden von Fotodetektoren (13), (23) nachgewiesen.

Die Signale des Fotodetektors (13) werden mit den Signalen der Referenz-Fotodiode (12) einem Differenzverstärker (14) zugeführt, der einen PI-Regler (15) ansteuert, welcher auf die Stromversorgung (16) der Laserdiode (1) wirkt.

Durch diesen Regelkreis wird die Wellenlänge der Laserdiode (1) auf einen bestimmten Wert an der Flanke des N-ten Transmissionsmaximums des Fabry-Perot-Interferometers (3) geregelt und stabilisiert.

Die Wellenlänge der zweiten Laserdiode (2) wird in gleicher Weise geregelt, mittels Fotodetektor (23), Referenz-Fotodiode (22), Differenzverstärker (24), PI-Regler (25) und Stromversorgung (26), aber auf ein anderes Transmissionsmaximum $N + \Delta N$. Die aus den beiden Wellenlängen gebildete effektive Wellenlänge beträgt

$$\Lambda_0 = \frac{L}{\Delta N} \qquad \text{(Gl. 6)}$$

wobei L der optische Weg eines Umlaufs durch das Fabry-Perot-Interferometer ist. $\Lambda_0$ läßt sich somit durch geeignete Wahl von L und $\Delta N$ in weiten Grenzen variieren.

Durch geeignete Auslegung der optischen Komponenten (insbesondere des freien Spektralbereichs und der Finesse des Fabry-Perot-Interferometers) und der Regelungselektronik gelingt es, die beiden Wellenlängen sehr gut (z.B. mit relativen Wellenlängenabweichungen von $10^{-8}$ oder weniger) auf eine Fabry-Perot-Interferometer-Transmission zu stabilisieren. Damit sind Meßbereiche von mehreren Metern möglich. Die auf z bezogene relative Meßunsicherheit hängt von der gewählten effektiven Wellenlänge ($\Lambda_0$) ab.

Die Stabilität der Lage der Transmissionsmaxima selbst ist insbesondere beeinflußt durch Änderung des optischen Wegs L eines Umlaufs durch das Fabry-Perot-Interferometer infolge Temperaturvariationen.

Es gilt:

$$\frac{dz}{\Lambda_0} = \frac{z}{\Lambda_0} \frac{dL}{L} \qquad \text{(Gl. 7)}$$

Verwendet man ein Fabry-Perot-Interferometer mit einem Abstandshalter zwischen den Spiegeln aus Zerodur (Temperaturausdehnung < $10^{-7}$/K) und stabilisiert dessen Temperatur auf 1 ° C konstant bzw. mißt diese Temperatur mit der entsprechenden Genauigkeit und berücksichtigt deren Einfluß auf die effektive Wellenlänge, so sind nach Gl. 7) sinnvolle Messungen über einen großen Meßbereich auch bei kleinen effektiven Wellenlängen ($\Lambda_0$) möglich, da dL in Gl. 7) lediglich den unberücksichtigten Teil der Wärmeausdehnung repräsentiert.

Eine alternative Anordnung ist in Fig. 2 dargestellt.

Licht von den beiden Laserdioden (1) und (2) wird mit einem teildurchlässigen Spiegel (43) vereinigt und als austretender Lichtstrahl (4) bereitgestellt.

Durch die Spiegelanordnung (19) und den Teilerspiegel (29) wird je ein Teil des Lichts der beiden Laserdioden (1), (2) auf getrennten Wegen dem hier planparallel gezeigten Fabry-Perot-Interferometer (32) zugeführt. In diesem Fall tritt das Licht auch getrennt aus und wird von nebeneinanderliegenden Fotodioden (13), (23) getrennt nachgewiesen. Die Regelung auf ein Maximum der Transmission des Fabry-Perot-Interferometers (32) erfolgt nach dem Lock-In-Verfahren mittels Lock-In-Verstärker (17), PI-Regler (15) und Stromversorgung (16) mit der Modulationsfrequenz eines Sinusgenerators (18) für die erste Laserdiode (1). Entsprechend sind Lock-In-Verstärker (27), PI-Regler (25), Stromversorgung (26) und Sinusgenerator (28) der zweiten Laserdiode (2) zugeordnet.

Natürlich sind die Art der Strahltrennung - polarisationsmäßig oder geometrisch -, die Ausführung des Fabry-Perot-Interferometers - konfokal (3) oder planparallel (32) - und die Art der Regelung - Flanken- oder Maximumregelung - beliebig kombinierbar. Die in der Zeichnung dargestellten Ausführungen sind lediglich Beispiele.

Bei geometrischer Trennung des Lichts, auch in Verbindung mit der Polarisationskennung, kann die Anordnung mit nur einem Fabry-Perot-Interferometer mehrmals im Verbund realisiert werden, so daß im Effekt 3 und mehr Wellenlängen mit gemeinsamer Stabilisierung im austretenden Lichtstrahl (4) vereinigt sind.

## Patentansprüche

1. Anordnung mit zwei Laserdioden (1), (2) zur Erzeugung von Licht mit zwei Wellenlängen mit stabilisierter Wellenlängendifferenz, dadurch gekennzeichnet, daß ein Teil des Lichts der zwei Laserdioden (1), (2) örtlich oder hinsichtlich der Polarisation unterschiedlich mit optischen Mitteln (42), (19), (29) in ein Fabry-Perot-Interferometer (3), (32) eingekoppelt wird und je für das Licht der ersten und zweiten Laserdiode (1), (2) ein Fotodetektor (13), (23) angeordnet ist, der im Verbund mit einer bekannten Regeleinrichtung die Wellenlänge der ersten oder zweiten Laserdiode (1), (2) jeweils auf ein unterschiedliches Transmissionsmaximum des Fabry-Perot-Interferometers (3), (32) stabilisiert, und ein weiterer Teil des Lichts der zwei Laserdioden (1) und 2) mit optischen Mitteln (41), (43) überlagert und als Ausgang der Anordnung bereitgestellt wird.

2. Anordnung nach Anspruch 1, dadurch gekennzeichnet, daß das Licht der zwei Laserdioden (1), (2) durch einen polarisierenden Teilspiegel (41) vereinigt und zugleich unterschiedlich linear polarisiert wird, durch einen Strahlteiler (42) ein Teil (4) des vereinigten Lichts ausgekoppelt und ein Teil in das Fabry-Perot-Interferometer (3) eingekoppelt wird; aus dem Fabry-Perot-Interferometer (3) ein Teil des Lichts ausgekoppelt und durch einen weiteren polarisierenden Teilspiegel (31) in das von der ersten

und zweiten Laserdiode (1), (2) kommende Licht aufgeteilt und je einem Fotodetektor (13), (23) zugeführt wird (Fig. 1).

3. Anordnung nach Anspruch 1, dadurch gekennzeichnet, daß je ein Teil des Lichts der zwei Laserdioden (1), (2) parallel versetzt in das Fabry-Perot-Interferometer (32) eingekoppelt wird und parallel versetzt ausgekoppelt und auf nebeneinanderliegende Fotodetektoren (13), (23) geleitet wird (Fig. 2).

4. Anordnung nach mindestens einem der Ansprüche 1 bis 3, dadurch gekennzeichnet, daß das Fabry-Perot-Interferometer (3) konfokal ist.

5. Anordnung nach mindestens einem der Ansprüche 1 bis 4, dadurch gekennzeichnet, daß von jeder Laserdiode (1), (2) zusätzlich ein Teil des Lichts auf je eine Referenzdiode (12), (22) geleitet wird und die Regeleinrichtung die Signale dieser Referenzdioden (12), (22) nach dem Verfahren der Flankenstabilisierung mit einbezieht (Fig. 1).

6. Anwendung der Anordnung nach mindestens einem der Ansprüche 1 bis 5 zur interferometrischen Längenmessung von großen Entfernungen über 1m.

7. Anwendung der Anordnung nach mindestens einem der Ansprüche 1 bis 5 zur interferometrischen Messung an Oberflächen, deren Rauhigkeit größer gleich der Laserwellenlänge ist.

8. Anwendung der Anordnung nach mindestens einem der Ansprüche 1 bis 5 zur holografischen Konturvermessung ausgedehnter Objekte.

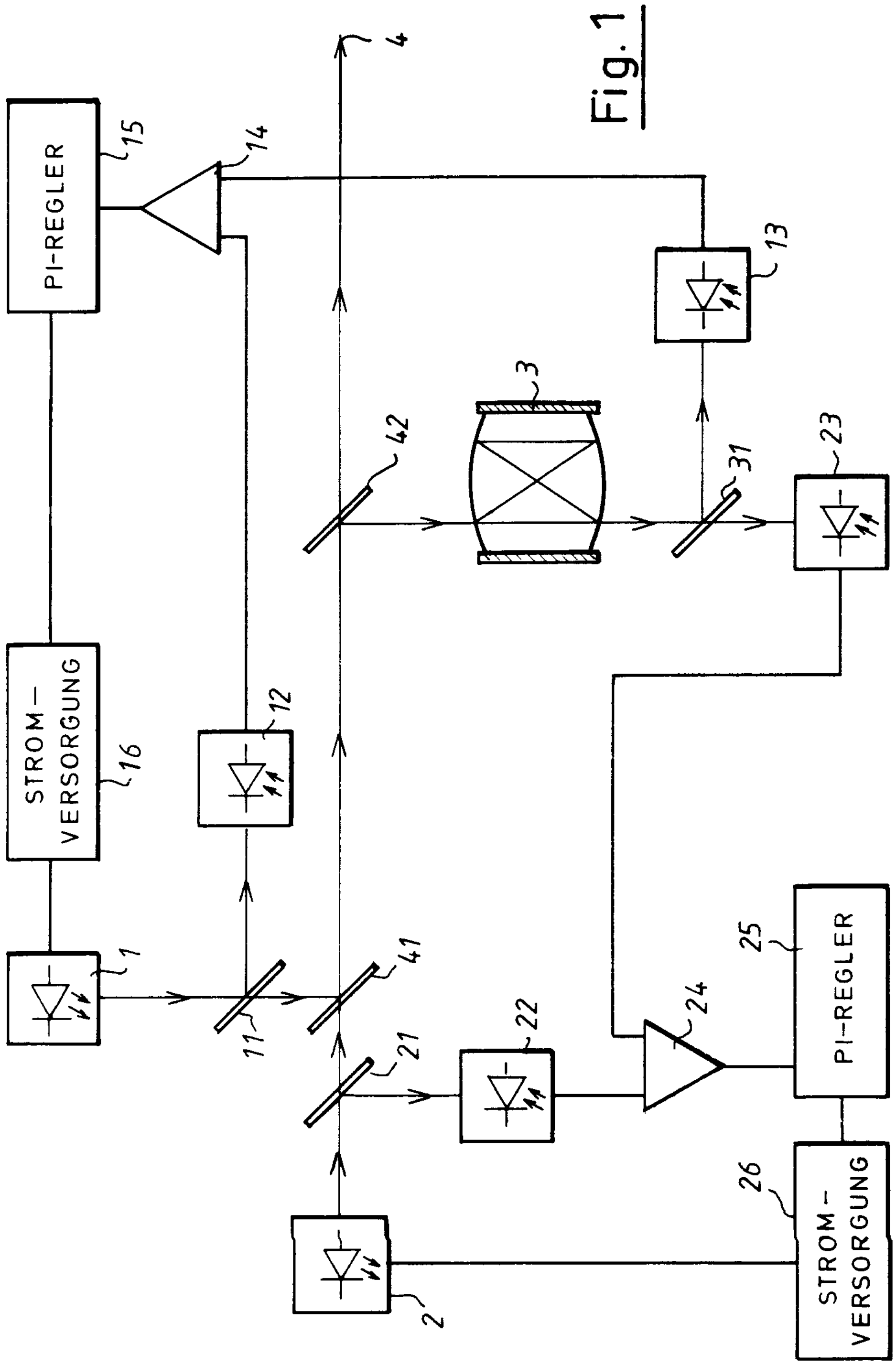
PI-REGLER
STROM-
VERSORGUNG
PI-REGLER
STROM-
VERSORGUNG
1
2
3
4
11
12
13
14
15
16
21
22
23
24
25
26
31
41
42

Fig. 1

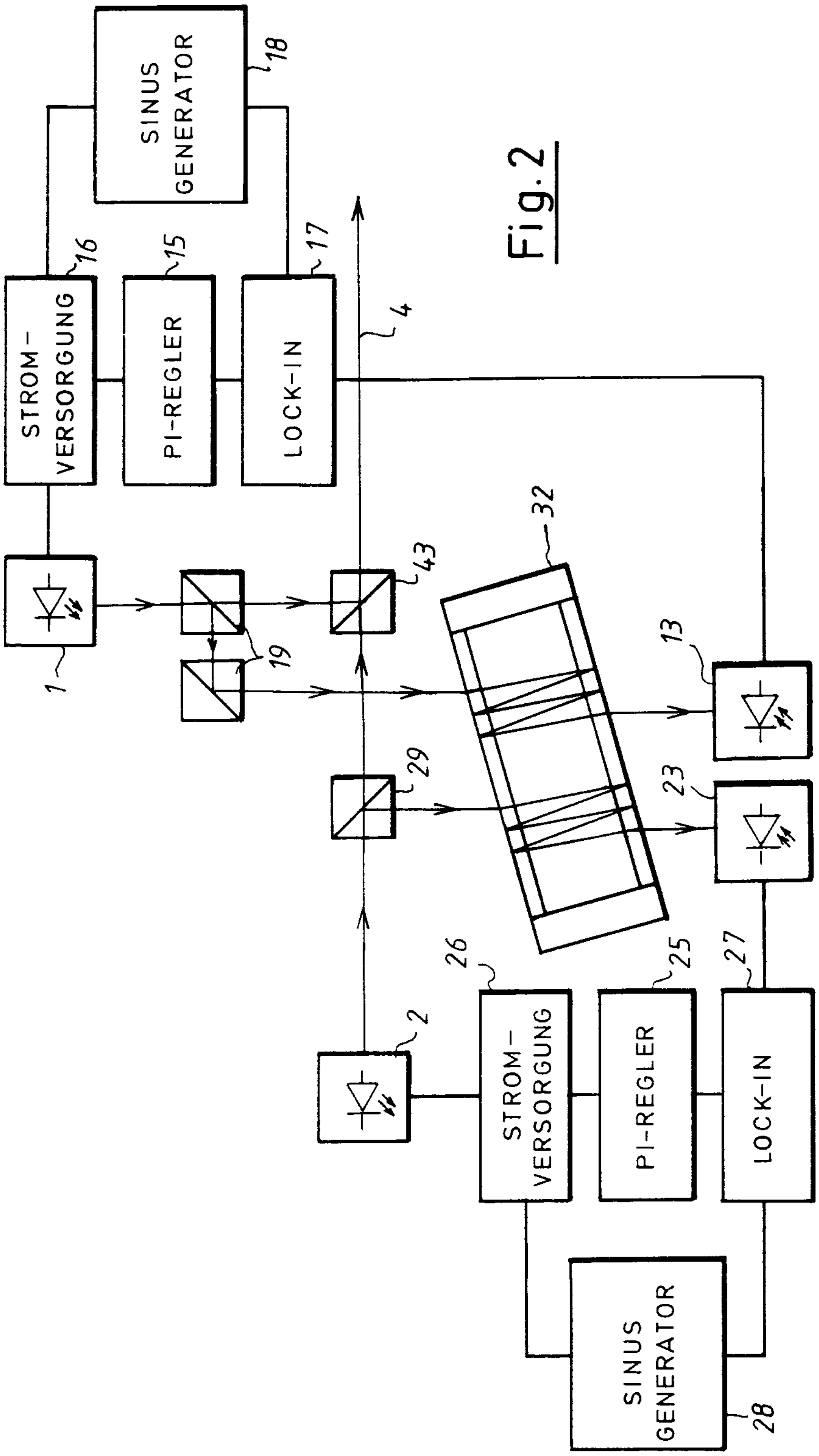
SINUS GENERATOR
18
STROM-VERSORGUNG
16
PI-REGLER
15
LOCK-IN
17
4
32
43
1
19
13
29
23
26
25
27
2
STROM-VERSORGUNG
PI-REGLER
LOCK-IN
SINUS GENERATOR
28

Fig. 2